Europäisches Patentamt

European Patent Office

Office européen des brevets

(19)

(11) Veröffentlichungsnummer: **0 214 451**
**A2**

(12) **EUROPÄISCHE PATENTANMELDUNG**

(21) Anmeldenummer: 86110616.9

(22) Anmeldetag: 31.07.86

(51) Int. Cl.⁴ **G11C 17/00** , G06F 9/24

(30) Priorität: 13.09.85 DE 3532744

(43) Veröffentlichungstag der Anmeldung:
18.03.87 Patentblatt 87/12

(84) Benannte Vertragsstaaten:
**DE FR GB SE**

(71) Anmelder: **VDO Adolf Schindling AG**
**Gräfstrasse 103**
**D-6000 Frankfurt/Main(DE)**

(72) Erfinder: **Reisch, Wolfgang**
**Röderrichstrasse 4**
**D-6000 Frankfurt am Main 90(DE)**
Erfinder: **Lukas, Bernhard**
**Hermann-Löns-Strasse 16**
**D-6096 Raunheim(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Anordnung zum Programmieren eines Festwertspeichers.**

(57) Bei einer Anordnung zum Programmieren eines Festwertspeichers ist der Festwertspeicher (EPROM, EEPROM) fest mit einer einen Mikrocomputer beinhaltenden Schaltung verbunden. Es ist eine Kontaktvorrichtung zur Verbindung der Anschlüsse des Festwertspeichers mit einem Programmiergerät vorgesehen. Die Schaltung enthält elektrische Mittel zur Entkopplung des Festwertspeichers vom Mikrocomputer. Über die Kontaktvorrichtung werden der Schaltung Signale bzw. Spannungen zugeführt, welche die Ausgänge des Mikrocomputers und gegebenenfalls dem Festwertspeicher zugeordneter Register in den hochohmigen Zustand bringen. Eine Entkopplung der Betriebsspannung der Schaltung und der vom Programmiergerät zugeführten Programmierspannung erfolgt mit Hilfe eines Widerstandes.

## Anordnung zum Programmieren eines Festwertspeichers

Die Erfindung betrifft eine Anordnung zum Programmieren eines Festwertspeichers. Bei Geräten mit Mikrocomputern ist das zum Betrieb des Mikrocomputers notwendige Programm in Festwertspeichern (auch Nur-Lese-Speicher oder Read-Only-Memory (ROM) genannt) abgelegt. Bei sehr großen Stückzahlen, beispielsweise bei Taschenrechnern, wird das Programm bereits bei der Herstellung der den Festwertspeicher bildenden integrierten Schaltung durch entsprechende Masken festgelegt. Für eine nachträgliche Programmierung sind verschiedene Festwertspeicher (PROM, EPROM, EEPROM) bekannt geworden. Damit ist es für den Hersteller eines einen Mikroprozessor enthaltenen Gerätes möglich, den Festwertspeicher sowie die anderen Komponenten des Mikrocomputers vom Hersteller zu beziehen und im Festwertspeicher ein für den speziellen Verwendungszweck angepaßtes Programm abzulegen.

Dieses Verfahren lohnt sich bereits bei kleineren Stückzahlen als es bei der Programmierung mittels Masken vom Hersteller der Fall ist. Hierzu werden die Festwertspeicher mit einem Programmiergerät verbunden und durch entsprechende Impulse mit dem Programm versehen. Bei bekannten Anordnungen werden die somit programmierten Festwertspeicher in Stecksockel der Geräte eingesetzt. Sie können somit wieder aus dem Gerät entfernt werden, falls eine Änderung des Programms durch Weiterentwicklung des Programms oder durch eine Änderung des Verwendungszwecks des Gerätes erforderlich ist.

Die Verwendung von Stecksockeln ist jedoch aus verschiedenen Gründen nachteilig. So bedeuten die Stecksockel zusätzlichen technischen und damit auch finanziellen Aufwand. Außerdem stellen die Prüfsockel eine Fehlerquelle dar. Schließlich ist bei extremer Miniaturisierung, wie sie beispielsweise mit der Hybridtechnik betrieben wird, ein Einsatz von Stecksockeln nur schwer möglich.

Aufgabe der Erfindung ist es daher, eine Anordnung zum Programmieren eines Festwertspeichers anzugeben, ohne die Nachteile eines Stecksockels in Kauf zu nehmen. Diese Aufgabe wird erfindungsgemäß dadurch gelöst, daß der Festwertspeicher fest mit einer einen Mikrocomputer beinhaltenden Schaltung verbunden ist, daß Mittel - (Kontaktvorrichtung) zur Verbindung der Anschlüsse des Festwertspeichers mit einem Programmiergerät vorgesehen sind und daß die Schaltung elektrische Mittel zur Entkopplung des Festwertspeichers von dem Mikrocomputer erhält.

Durch die erfindungsgemäße Anordnung ist es möglich, einen fest in ein Gerät eingebauten Festwertspeicher wiederholt zu programmieren. Der der Programmierung vorangehende Löschvorgang ist ohnehin leicht möglich -bei den üblichen EPROMs durch UV-Bestrahlung und bei den EEPROMs durch entsprechende elektrische Impulse.

Weiterbildungen der Erfindung beschäftigen sich damit, daß zur Entkopplung des Festwertspeichers vom Mikrocomputer die Ausgänge des Mikrocomputers -vorzugsweise mit einem Reset-Befehl -in den hochohmigen Zustand geschaltet werden, daß ein dem Festwertspeicher zugeordnetes Adressenregister (latch) dadurch gesperrt wird, daß die Ausgänge in den hochohmigen Zustand geschaltet werden und daß nicht in den hochohmigen Zustand schaltbare Ausgänge mit Entkopplungswiderständen versehen sind.

Bei einer weiteren Ausgestaltung der Erfindung wird der Programmierspannungs-Anschluß des Festwertspeichers über einen Widerstand an die Betriebsspannung angeschlossen und über die Kontaktvorrichtung mit der Programmierspannung aus dem Programmiergerät versorgt.

Ein Programmierimpuls-Eingang des Festwertspeichers wird gemäß einer Weiterbildung der Erfindung über einen Widerstand mit einer Betriebsspannung verbunden und über einen Kontakt der Kontaktvorrichtung mit einem Programmierimpuls-Ausgang des Programmiergerätes.

Die erfindungsgemäße Anordnung hat den Vorteil, daß das betreffende Gerät vollständig hergestellt werden kann und erst danach und wiederholt Programme eingelesen werden können.

So kann beispielsweise nach der Fertigstellung eines Gerätes zunächst ein Testprogramm geladen werden, um das Gerät leicht zu testen. Anschließend wird dann das endgültige Programm eingeschrieben.

Ferner können während der Lebensdauer eines Gerätes entstehende Verbesserungen des Programms ohne mechanische Änderungen, beispielsweise Auslöten des integrierten Schaltkreises, eingeführt werden.

Schließlich ist es unter Anwendung der Erfindung möglich, Geräte, welche durch verschiedene Programme an ihre Anwendungen anzupassen sind, ohne spezielles Programm herzustellen und auf Lager zu halten und erst dann speziell zu programmieren, wenn der Verwendungszweck des einzelnen Gerätes bekannt ist.

Weitere Ausgestaltungen der Erfindung sind dadurch gekennzeichnet, daß die Kontaktvorrichtung über Kontakte für Adressen, Daten, Programmierspannung, Programmierimpuls, Reset und gegebenenfalls weitere Spannungen und/oder Impulse aufweist und daß die Kontakte derart angeordnet sind, daß sie mit zugehörigen Stellen der Leiterbahnen der Schaltung und/oder mit Anschlüssen der in der Schaltung enthaltenen Bauteile Kontaktpaare bilden. Geeignete Kontaktvorrichtungen sind an sich bekannt und werden als sogenannte Prober bei der Prüfung von Schaltungen häufig angewendet.

Die Leiterbahnen können dabei mit Kontaktstücken versehen sein oder lediglich frei von nichtleitenden Überzügen sein. Die Kontaktstücke können Teile der Leiterbahnen, die mit einer Edelmetallschicht versehen sind, oder in die Leiterbahnen eingesetzte Kontakte sein, wie sie in der Verbindungstechnik üblich sind.

Schließlich können die zur Programmierung dienenden Kontakte an einer Stelle der Leiterplatte zusammengefaßt und gegebenenfalls mit einem Vielfachstecker versehen sein, was nützlich sein kann, wenn häufig Programmänderungen zu erwarten sind.

Die aufgeführten Vorzüge der erfindungsgemäßen Anordnung sind insbesondere bei einer Schaltung in Hybridtechnik vorteilhaft, in welche der Festwertspeicher ohne Verwendung eines Stecksockels vorzugsweise als Chip-Bauelement eingelötet ist.

Schließlich umfaßt die Erfindung eine Vorrichtung zum Programmieren eines in eine Schaltung eingebauten Festwertspeichers mit einem Programmiergerät, welches durch eine Kontaktvorrichtung, mit welcher die Ausgänge des Programmiergerätes mit Anschlüssen des Festwertspeichers verbindbar sind, gekennzeichnet ist. Eine Weiterbildung der Vorrichtung ist dadurch gekennzeichnet, daß die Kontaktvorrichtung weitere Kontakte umfaßt, welche der Schaltung Signale bzw. Spannung zuführen, die eine Entkopplung des Festwertspeichers von den übrigen Teilen der Schaltung bewirken.

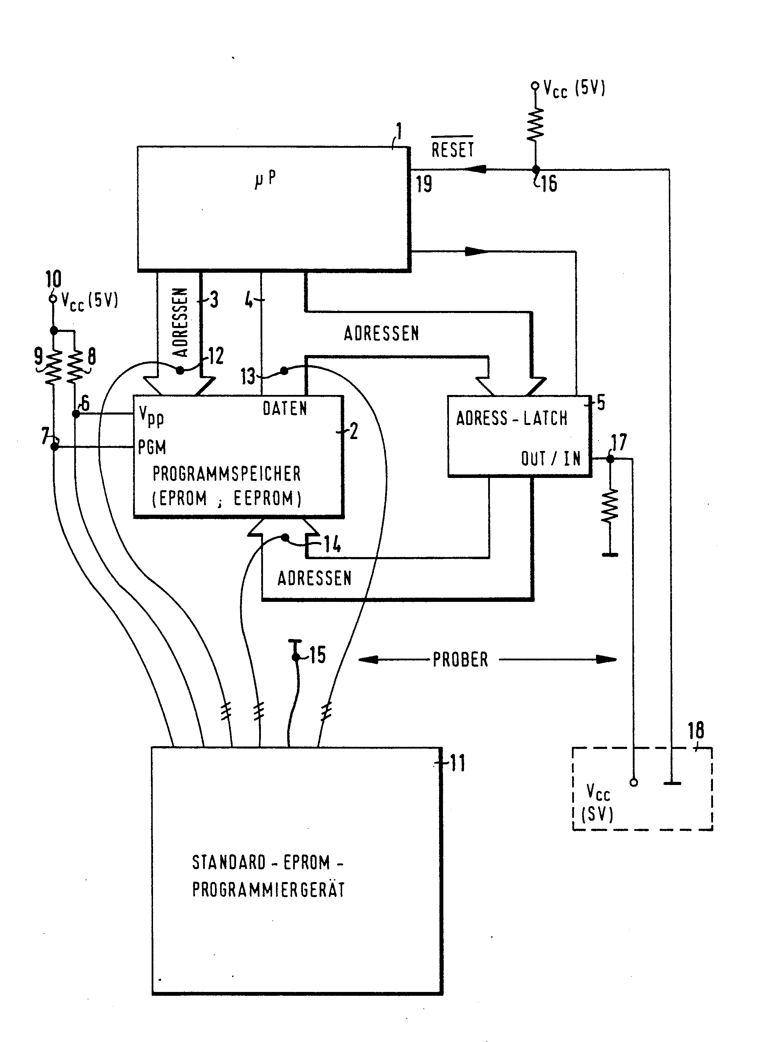

Ein Ausführungsbeispiel der Erfindung ist in der Zeichnung dargestellt und in der nachfolgenden Beschreibung näher erläutert.

Die Zeichnung stellt teilweise als Blockschaltbild einen Ausschnitt aus einem Gerät dar, welches einen Mikroprozessor 1 und einen zur Speicherung des Programms dienenden Festwertspeicher 2 enthält. Der Mikroprozessor 1 arbeitet nun mit dem Festwertspeicher derart zusammen, daß der Mikroprozessor 1 über einen Adreßbus 3 Adressen an den Festwertspeicher 2 gibt, worauf dieser die für den jeweils nächsten Programmschritt erforderlichen Daten über einen Datenbus 4 an den Mikroprozessor 1 gibt.

Bei der in der Zeichnung dargestellten Anordnung liegt insofern noch eines Besonderheit vor, als anstelle eines Mikroprozessors 1 ein Mikrocomputer, beispielsweise mit der Typenbezeichnung 7811, verwendet wird, bei welchem 16-Bit-Adressen an ein entsprechendes EPROM gegeben werden. Davon werden jeweils 8-Bit einer Adresse über den Adreßbus 3 geleitet, während die weiteren 8-Bit nach einem Multiplex-Verfahren über den Datenbus 4 und ein Adreßregister 5 den Adresseneingängen des EPROMs 2 zugeführt werden. Von den weiteren Anschlüssen des EPROMs 2 sind lediglich die Eingänge Vpp und PGM für die Programmierspannung und für den Programmierimpuls dargestellt.

Beim normalen Betrieb, d. h. wenn ein gespeichertes Programm schrittweise aus dem EPROM augelesen wird, sind die Eingänge 6 und 7 über je einen Widerstand 8 und 9 mit dem Pol 10 der Betriebsspannung (Vcc) verbunden.

Zur Programmierung wird nun das Programmiergerät 11 über eine geeignete Kontaktvorrichtung mit den Punkten 6, 7, 12, 13, 14 und 15 der Schaltung verbunden. Dabei sind die Verbindungen zu den Punkten 12, 13 und 14 jeweils achtfach. Gleichzeitig werden die Punkte 16 und 17 mit einer zusätzlichen Schaltung 18 verbunden. Dadurch wird bewirkt, daß der Reset-Eingang des Mikroprozessors 1 Massepotential erhält, worauf die Adressen-und Datenausgänge des Mikrocomputers in den hochohmigen Zustand geschaltet werden. Über den Schaltungspunkt 17 gelangt die Spannung Vcc an den OUT/EN-Eingang des Adressenregisters 5, worauf auch dessen Ausgänge in den hochohmigen Zustand gelangen.

Zu Beginn der Programmierung wird die von dem Hersteller des EPROM vorgesehene Programmierspannung, welche beispielsweise einen Wert von 12V aufweist, dem Schaltungspunkt 6 zugeführt. Daraufhin wird über die Schaltungspunkte 12 und 14 die erste Adresse und über den Schaltungspunkt 13 die zu dieser Adresse gehörenden Daten eingegeben. Als Abschluß dieser Eingabe wird in an sich bekannter Weise der Eingang PGM des EPROM über den Schaltungspunkt 7 mit einem Programmierimpuls belegt. Daraufhin werden die nächste Adresse und die zugehörigen Daten eingegeben usw.

Ist das gesamte Programm eingegeben, wird die Kontaktvorrichtung von der Schaltung entfernt. An den Eingängen Vpp und PGM liegt dann wieder die Betriebsspannung Vcc und der Programmspeicher steht für den normalen Lese-Betrieb zur Verfügung.

Bei dem in der Figur dargestellten Ausführungsbeispiel sind die Ausgänge des Mikrocomputers 1 und des Adressenregisters 5 in den hochohmigen Zustand schaltbar. Es sind jedoch an den Bus andere Bausteine, z. B. Port-Bausteine, anschließbar, deren Ausgänge sich nicht in den hochohmigen Zustand versetzen lassen. Hier kann eine Entkopplung durch geeignete Widerstände vorweggenommen werden, wie es in der Figur im Zusammenhang mit den Anschlüssen Vpp und PGM des EPROMs dargestellt ist.

## Ansprüche

1. Anordnung zum Programmieren eines Festwertspeichers, dadurch gekennzeichnet, daß der Festwertspeicher (2) fest mit einer einen Mikrocomputer (1) beinhaltenden Schaltung verbunden ist, daß Mittel (Kontaktvorrichtung) zur Verbindung der Anschlüsse des Festwertspeichers (2) mit einem Programmiergerät (11) vorgesehen sind und daß die Schaltung elektrische Mittel zur Entkopplung des Festwertspeichers (2) von dem Mikrocomputer (1) enthält.

2. Anordnung nach Anspruch 1, dadurch gekennzeichnet, daß der Festwertspeicher (2) aus einem oder mehreren löschbaren, programmierbaren Nur-Lese-Speichern (EPROMs) besteht.

3. Anordnung nach Anspruch 1, dadurch gekennzeichnet, daß der Festwertspeicher (2) aus einem oder mehreren elektrisch löschbaren, programmierbaren Nur-Lese-Speichern (EEPROMs) besteht.

4. Anordnung nach einem der vorangehenden Ansprüche, dadurch gekennzeichnet, daß zur Entkopplung des Festwertspeichers (2) vom Mikrocomputer (1) die Ausgänge des Mikrocomputers (1) -vorzugsweise mit einem Reset-Befehl -in den hochohmigen Zustand geschaltet werden.

5. Anordnung nach einem der vorangehenden Ansprüche, dadurch gekennzeichnet, daß ein der Schaltung zugeführtes Signal ein dem Festwertspeicher (2) zugeordnetes Adressenregister (latch) (5) sperrt.

6. Anordnung nach Anspruch 5, dadurch gekennzeichnet, daß durch eine der Schaltung zugeführte Spannung die Ausgänge des Adressenregisters (5) hochohmig geschaltet werden.

7. Anordnung nach Anspruch 1, dadurch gekennzeichnet, daß ein Programmierspannungs-Anschluß (Vpp) des Festwertspeichers (2) über einen Widerstand (8) mit einer Betriebsspannungsquelle (10) und über einen Kontakt (6) der Kontaktvorrichtung mit einem Programmierimpuls-Ausgang des Programmiergerätes (11) verbunden ist.

8. Anordnung nach Anspruch 1, dadurch gekennzeichnet, daß ein Programmierimpuls-Eingang (PGM) des Festwertspeichers (2) über einen Widerstand (9) mit einer Betriebsspannungsquelle (10) und über einen Kontakt (7) der Kontaktvorrichtung mit einem Programmierimpuls-Ausgang des Programmiergerätes (11) verbunden ist.

9. Anordnung nach Anspruch 1, dadurch gekennzeichnet, daß die Kontaktvorrichtung über Kontakte für Adressen, Daten, Programmierspannung, Programmierimpuls, Reset-und gegebenenfalls weitere Spannungen und/oder Impulse aufweist und daß die Kontakte derart angeordnet sind, daß sie mit zugehörigen Stellen der Leiterbahnen der Schaltung Kontaktpaare bilden.

10. Anordnung nach Anspruch 9, dadurch gekennzeichnet, daß die Leiterbahnen mit Kontaktstücken versehen sind.

11. Anordnung nach Anspruch 9, dadurch gekennzeichnet, daß die Leiterbahnen an den die Kontaktpaare bildenden Stellen frei von nichtleitenden Überzügen sind.

12. Anordnung nach Anspruch 1, dadurch gekennzeichnet, daß die Schaltung in Hybridtechnik ausgebildet ist, in welche der Festwertspeicher (2) ohne Verwendung eines Stecksockels, vorzugsweise als Chip-Bauelement, eingelötet ist.

13. Vorrichtung zum Programmieren eines in eine Schaltung eingebauten Festwertspeichers (2) mit einem Programmiergerät (11), gekennzeichnet durch eine Kontaktvorrichtung, mit welcher die Ausgänge des Programmiergerätes (11) mit Anschlüssen des Festwertspeichers (2) verbindbar sind.

14. Vorrichtung nach Anspruch 13, dadurch gekennzeichnet, daß die Kontaktvorrichtung weitere Kontakte umfaßt, welche der Schaltung Signale bzw. Spannungen zuführen, die eine Entkopplung des Festwertspeichers (2) von den übrigen Teilen (1, 5) der Schaltung bewirken.

15. Anordnung nach Anspruch 4, dadurch gekennzeichnet, daß weitere an den Festwertspeicher (2) angeschlossene Bausteine, deren Ausgänge nicht in den hochohmigen Zustand schaltbar sind, über Entkopplungswiderstände an den Festwertspeicher (2) angeschlossen sind.